# EUROPEAN PATENT SPECIFICATION

(11) **EP 0 902 612 B1**
(45) Date of publication and mention of the grant of the patent: **02.04.2003**
(21) Application number: 98306259.7
(22) Date of filing: 05.08.1998
(51) Int. Cl.: H05K 9/00

(54) **Seam structure for enclosures**
Fügeanordnung für Gehäuse
Structure de joint pour boîtier

(30) Priority: 09.09.1997 US 925983
(43) Date of publication of application: 17.03.1999
(73) Proprietor: Hewlett-Packard Company, A Delaware Corporation, Palo Alto, CA 94304 (US)
(72) Inventor: Cherniski, Andrew M., Rescue, California 95672 (US); Wortman, Michael, Roseville, California 95747 (US)
(74) Representative: Powell, Stephen David

(56) References cited:
- EP-A- 0 727 853
- PATENT ABSTRACTS OF JAPAN vol. 095, no. 004, 31 May 1995 (1995-05-31) & JP 07 030277 A (TOSHIBA CORP), 31 January 1995 (1995-01-31)
- PATENT ABSTRACTS OF JAPAN vol. 097, no. 005, 30 May 1997 (1997-05-30) & JP 09 027691 A (FUJI ELECTRIC CO LTD), 28 January 1997 (1997-01-28)
- PATENT ABSTRACTS OF JAPAN vol. 095, no. 011, 26 December 1995 (1995-12-26) & JP 07 221481 A (MATSUSHITA ELECTRIC IND CO LTD), 18 August 1995 (1995-08-18)

## Description

The present invention relates to seam structures and in particular to an all-tab seam structure for electro-magnetic interference containment.

Most complex electrical circuits must be housed to shield the circuits from electro-magnetic interference ("EMI") from external sources of electro-magnetic radiation. The same housing protects other electrical devices from the electro-magnetic radiation generated by the electrical circuits themselves. Housings which reduce EMI are called electro-magnetic containment ("EMC") enclosures herein. EMC enclosures must contain stray electrical noise signals below the limit set by the regulating authorities while remaining economical to fabricate. Despite the best efforts of design engineers, the EMC enclosures of some electrical systems fail to conform to the legally mandated limit. Often, the enclosure's fixed enclosure seams are the cause for this failure.

Fixed enclosure seams are the riveted, screwed, or folded unions that join sheet metal stock to form the enclosure's box structure. They can be excessively "leaky" to electro-magnetic radiation when the joined metal parts are warped or contaminated. Even a small amount of warpage, contamination, or corrosion is enough to cause serious EMI problems. Seam leakage often varies from one production unit to another, causing some completed systems to fail EMI qualification tests while others from the same production line pass with adequate margins.

Consistent seam containment relies on intimate electrical contact between the mated parts. The maximum acceptable spacing between the contact points is a function of the maximum emission frequency of the system and the level of shielding required. As the emission frequency increases, the distance between the contact points must decrease. Likewise, as shielding requirements increase, contact spacing must further decrease. Practical limits quickly come into play.

In a riveted structure consisting of two pieces of overlapping metal, contact can only be guaranteed at the rivet locations. A robust seam needs rivets spaced 1.27 cm (½ inch) apart or less. This solution provides limited performance margins and is expensive to manufacture.

A manufacturing solution that does not require discrete fasteners and that greatly reduces the distance between contact points along the fixed enclosure seam would be desirable.

The preferred embodiment of the present invention is suitable for enclosures having orthogonal panel orientations and at least some material overlap between the panels. The all-tab structure comprises two pieces of sheet metal joined at right angles, one with an array of round-top tabs and the other with a matching set of slots. The tabs fit orthogonally into the slots of the mating panel and are individually or jointly folded over until they lay flat against the mating part. Alignment of the round-top tabs into the slots is facilitated by punching a round hole directly over each slot. The diameter of the round hole is approximately 2/3 the size of the slot length.

A superior electrical contact is formed over most or all of the tab span length. In tests up to 2 GHz, an EMC enclosure using this embodiment exhibited 60 dB of EMI reduction, versus only 30 dB for an enclosure using rivets.

The preferred embodiment of the present invention will now be described in detail with reference to the figures listed and described below.
Fig. 1 is a cut-away top perspective of the first embodiment of the present invention; and
Fig. 2 is a graph showing the performance of the first embodiment of the present invention.

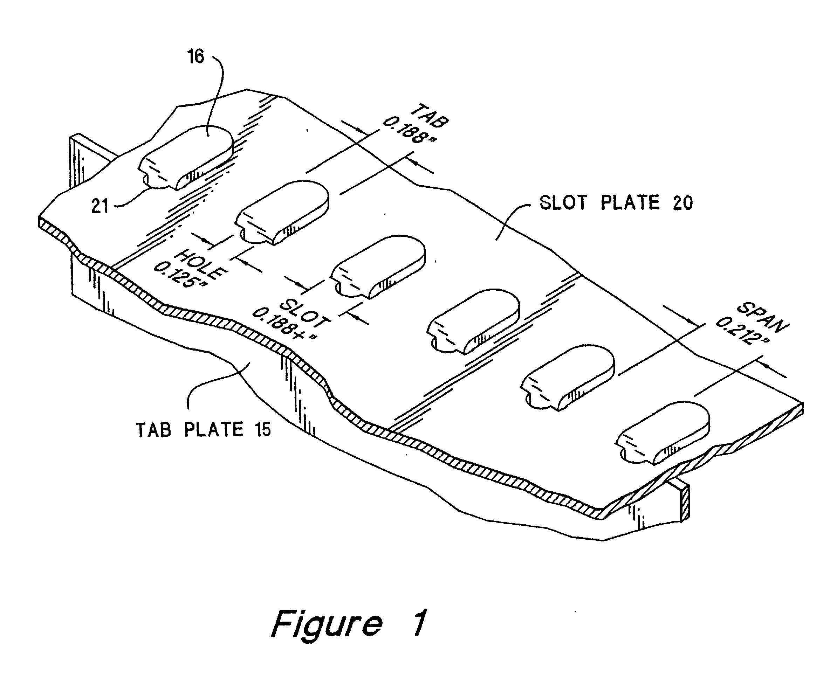

As shown in Fig. 1, a first embodiment of the present invention comprises two pieces of sheet metal joined at right angles, a tab plate 15 with an array of round-top tabs 16 and a slot plate 20 with a matching set of slots 21. Tabs 16 fit orthogonally into slots 21 of slot plate 20 and are individually or jointly folded over until they lay flat against slot plate 20.

Alignment of the round-top tabs into the slots is facilitated by punching a round hole directly over each slot. The diameter of the round holes is approximately 2/3 the size of the slot length.

An EMC structure using this construction was fabricated with a tab/slot dimension of 0.47 cm (0.188") and a spacing between the tabs of 0.53 cm (0.212"). The metal sheet stock for this test structure consisted of 16 gauge zinc plated steel. The tabs were folded in the direction needed to cover the slot hole open to the high energy side of the seam. The high energy side of the seam is defined as the side forming the interior of the structure which contains the noise source. When tab 16 is folded into place, its bend radius mechanically interferes with the edge of the mating slot. A high force contact is formed, causing all but the round hole in the slot to be electrically sealed. The 0.31 cm (1/8") holes 21 are the only exposed apertures at the tab location and are covered by the folded tabs 16. As the uncovered portion of the hole provides no path to the inside of the structure, no breach of the containment structure occurs.

The span between the tabs, 0.53 cm (0.212"), is either flat or slightly convex (upward direction). The action of folding the tabs over causes the mating slot plate to mechanically interfere with the span between the tabs at high force. A superior electrical contact is formed over most or all of the tab span length. The portion of the slot hole open to the box interior is reduced to an insignificant size by the larger tab fold.

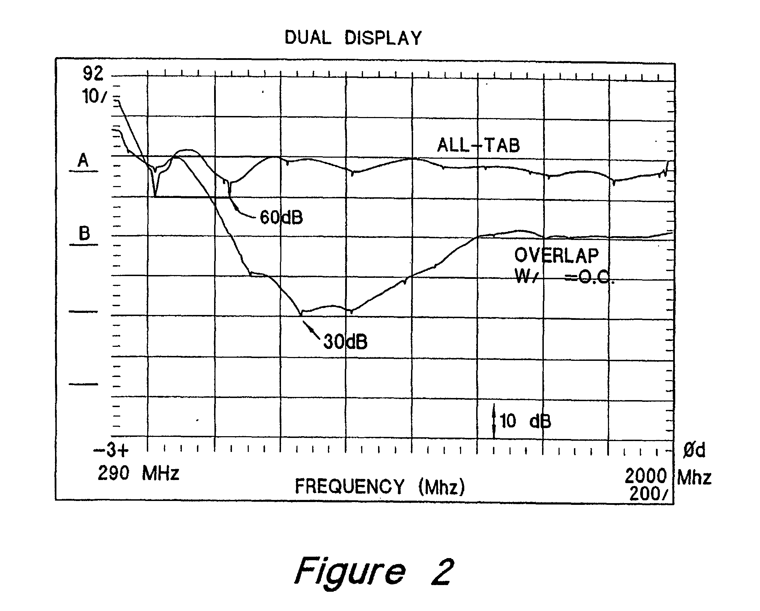

The maximum exposed aperture in the structure of this first embodiment is the above mentioned array of 0.31 cm (1/8") holes that are loosely covered by a metal tab. The performance of this structure as an EMC structure is excellent. As shown by the spectral plot in Fig. 2, tests using a radiated shielding effectiveness system show that the structure of the first embodiment of the present invention has superior performance over a conventional structure using a seam that is riveted on 1.27 cm (½ inch) centres.

Fig. 2 shows the performance of the first embodiment's all-tab structure in the frequency range of 290 MHz to 2.0 GHz. The present invention provides 60 dB of signal attenuation, while the conventional structure provides only 30 dB of attenuation.

The first embodiment of the present invention is suitable for enclosure implementations having orthogonal panel orientations and some material overlap. Its superior EMC performance makes it an attractive and inexpensive alternative to more conventional approaches. In applications where a very level of attenuation is required, the present invention may be the only reasonable solution.

## Claims

1. A method for fabricating fixed enclosure seams, the method comprising the steps of:
fabricating a plurality of tabs (16) in a first tab plate (15),
fabricating a plurality of slots (21) in a first slot plate (20);
fitting the tabs of the tab plate into the slots in the slot plate; and
folding the tabs flat against the slot plate.

2. A fixed enclosure seam comprising:
a first tab plate (15) having a plurality of tabs (16) along a first seam edge; and
a first slot plate (20) having a plurality of slots (21) along a first seam edge, the tabs of the tab plate being inserted into the slots of the slot plate and folded against the slot plate to form the fixed enclosure seam.

3. The fixed enclosure seam of claim 2, wherein the slots further comprise a round hole centred over each slot, the round hole facilitating the alignment of the tabs of the tab plate with the slots of the slot plate.

4. The fixed enclosure seam of claim 2 or 3, wherein the spacing of the slots is determined by the frequency shielding requirement of the electronic equipment, with higher frequency shielding requirements requiring closer spacing of the tabs and the corresponding slots.

5. The fixed enclosure seam of claim 3, wherein the tabs are folded over to cover the slot hole open to the high energy side of the seam.

6. The fixed enclosure seam of any of claims 2 to 5, wherein the tabs are spaced no more than 0.127 cm (½ inch) apart, centre-to-centre.

7. A housing for electric equipment and having at least one enclosure seam according to any of claims 2 to 6.

## Patentansprüche

1. Ein Verfahren zum Herstellen von Festgehäusenähten, wobei das Verfahren folgende Schritte aufweist:
Herstellen einer Mehrzahl von Vorsprüngen (16) in einer ersten Vorsprungsplatte (15),
Herstellen einer Mehrzahl von Schlitzen (21) in einer ersten Schlitzplatte (20);
Einpassen der Vorsprünge der Vorsprungsplatte in die Schlitze in der Schlitzplatte; und
Falten der Vorsprünge flach gegen die Schlitzplatte.

2. Eine Festgehäusenaht, die folgende Merkmale aufweist:
eine erste Vorsprungsplatte (15) mit einer Mehrzahl von Vorsprüngen (16) entlang einer ersten Nahtkante; und
eine erste Schlitzplatte (20) mit einer Mehrzahl von Schlitzen (21) entlang einer ersten Nahtkante, wobei die Vorsprünge der Vorsprungsplatte in die Schlitze der Schlitzkarte eingebracht sind und gegen die Schlitzplatte gefaltet sind, um die Festgehäusenaht zu bilden.

3. Die Festgehäusenaht gemäß Anspruch 2, bei der die Schlitze ferner ein rundes Loch aufweisen, das über jedem Schlitz mittig angeordnet ist, wobei das runde Loch die Ausrichtung der Vorsprünge der Vorsprungsplatte mit den Schlitzen der Schlitzplatte erleichtert.

4. Die Festgehäusenaht gemäß Anspruch 2 oder 3, bei der die Beabstandung der Schlitze durch die Frequenzabschirmungsanforderung der elektronischen Ausrüstung bestimmt ist, wobei höhere Frequenzabschirmungsanforderungen eine geringere Beabstandung der Vorsprünge und der entsprechenden Schlitze erfordern.

5. Die Festgehäusenaht gemäß Anspruch 3, bei der die Vorsprünge umgefaltet sind, um das Schlitzloch abzudecken, das zur Hochenergieseite der Naht hin offen ist.

6. Die Festgehäusenaht gemäß einem der Ansprüche 2 bis 5, bei der die Vorsprünge um nicht mehr als 0,127 cm (1/2 Zoll), Mitte-zu-Mitte, voneinander beabstandet sind.

7. Ein Gehäuse für elektrische Geräte, das zumindest eine Gehäusenaht gemäß einem der Ansprüche 2 bis 6 aufweist.

## Revendications

1. Procédé pour fabriquer des lignes d'assemblage d'enceinte fixées, le procédé comportant les étapes consistant à :
fabriquer une pluralité de pattes (16) dans une première plaque à pattes (15),
fabriquer une pluralité de fentes (21) dans une première plaque à fentes (20),
agencer les pattes de la plaque à pattes dans les fentes de la plaque à fentes, et
plier les pattes à plat contre la plaque à fente.

2. Ligne d'assemblage d'enceinte fixée comportant :
une première plaque à pattes (15) ayant une pluralité de pattes (16) le long d'un premier bord formant ligne d'assemblage, et
une première plaque à fentes (20) ayant une pluralité de fentes (21) le long d'un premier bord formant ligne d'assemblage, les pattes de la plaque à pattes étant insérées dans les fentes de la plaque à fentes et pliées contre la plaque à fentes pour former la ligne d'assemblage d'enceinte fixée.

3. Ligne d'assemblage d'enceinte fixe selon la revendication 2, dans laquelle les fentes comportent en outre un trou rond centré au-dessus de chaque fente, le trou rond facilitant l'alignement des pattes de la plaque à pattes avec les fentes de la plaque à fentes.

4. Ligne d'assemblage d'enceinte fixée selon la revendication 2 ou 3, dans laquelle l'écartement des fentes est déterminé par l'impératif de protection vis-à-vis d'une fréquence de l'équipement électronique, des impératifs de protection vis-à-vis d'une fréquence plus élevée nécessitant un écartement plus serré des pattes et des fentes correspondantes.

5. Ligne d'assemblage d'enceinte fixe selon la revendication 3, dans laquelle les pattes sont repliées pour recouvrir le trou de fente ouvert, sur le côté d'énergie élevée de la ligne d'assemblage.

6. Ligne d'assemblage d'enceinte fixe selon l'une quelconque des revendications 2 à 5, dans laquelle les pattes sont espacées d'une valeur qui n'est pas plus grande que 0,127 cm (0,5 pouce), de centre à centre.

7. Boîtier d'équipement électronique et ayant au moins une ligne d'assemblage d'enceinte selon l'une quelconque des revendications 2 à 6.
